# EUROPEAN PATENT SPECIFICATION

(11) **EP 2 768 023 B1**
(45) Date of publication and mention of the grant of the patent: **09.10.2019**
(21) Application number: 13155765.4
(22) Date of filing: 19.02.2013
(51) Int. Cl.: G02B 5/20, H01L 31/0216, H01L 27/144, H01L 31/18, H01L 27/146

(54) **Method of producing a radiation sensor semiconductor device comprising a multiple colour filter**
Verfahren zur Herstellung eines Strahlungssensorhalbleiterbauelements mit Mehrfarbenfilter
Procédé de production de dispositif semi-conducteur à capteur de rayonnement comprenant un filtre de couleurs multiples

(43) Date of publication of application: 20.08.2014
(73) Proprietor: ams AG, 8141 Premstätten (AT)
(72) Inventor: Minixhofer, Rainer, 8141 Unterpremstätten (AT)
(74) Representative: Epping - Hermann - Fischer

(56) References cited:
- US-A1- 2003 030 715
- US-A1- 2006 115 749
- US-A1- 2010 117 991
- US-A1- 2012 242 940

## Description

Radiation sensor semiconductor devices, especially for detecting ambient light, comprise RGB polymer filters as colour filters, which use metallic components in the polymer to establish the desired absorption characteristics.

US 2008/0230753 A1 discloses the production of a multiple colour filter on an optically transparent substrate by application of an inkjet method.

US 2010/0117991 A1 discloses an image input-output device comprising a photodetector element and a color layer. A method for manufacturing the device comprises arranging an element formation layer over a substrate and a protective film over the element formation layer. A light blocking film is formed over the protective film and etched using resist masks to form light blocking layers. Color layers having the same color or different colors such as red, green and blue are formed by an inkjet method between the light blocking layers serving as partition layers.

US 2006/0115749 A1 discloses a method of forming color filters. A bank structure, which can be a semiconductor substrate material, is arranged on a substrate to form grooves, whose surface is made lyophilic. Red, green and blue ink ejected from a liquid droplet ejection head is filled into the grooves.

US 2003/0030715 A1 discloses an inkjet printing method for manufacturing a color filter on a substrate comprising a lattice structure. A charge-coupled device detects the intensity of light passing through the substrate for determining the centre position of the lattice structure. Ink droplets are discharged on the substrate and uniformly distributed in the lattice structure.

US 2012/0242940 A1 discloses a method for producing a color filter on a silicon substrate comprising an imaging device. A color pattern may be provided on the front or back substrate surface, and the color may be applied, inter alia, by an inkjet method producing a film thickness of 0.1 µm to 10 µm. It is an object of this invention to facilitate the production of radiation sensor semiconductor devices.

This object is achieved with the method according to claim 1. Variants derive from the dependent claims.

The following is a detailed description of examples of the method of production.
- Figure 1: is a perspective view of a sensor device.
- Figure 2: shows a pixel pattern comprising squares.
- Figure 3: shows a further pixel pattern comprising hexagons.
- Figure 4: shows a further pixel pattern comprising octagons.

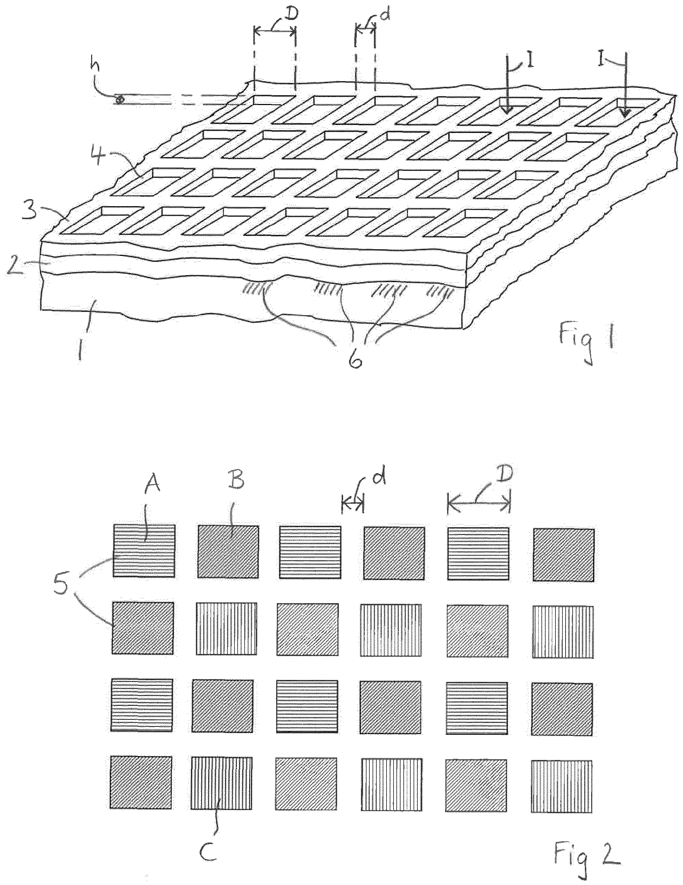

Figure 1 is a perspective view of a sensor device comprising a semiconductor layer 1, a dielectric layer 2 above the semiconductor layer 1, and a web 3 forming a plurality of recesses 4. The semiconductor layer 1 may comprise any semiconductor body like a silicon substrate, for example, which is provided with at least one integrated radiation sensor 6 like a photodiode, for example, which is schematically indicated in Figure 1 by hatched regions in the semiconductor layer 1. A plurality of radiation sensors 6 may be provided to form an array of pixels. Structured metal layers of a wiring may be embedded in the dielectric layer 2. The wiring may provide electric connections for the integrated radiation sensor or array of radiation sensors and/or for further integrated components forming an integrated circuit, for example. The dielectric layer 2 may also be provided as a covering or passivating layer above the integrated radiation sensor or array of radiation sensors. The web 3 may be a semiconductor material like silicon, for instance. The web 3 can be formed by applying its material on the entire surface of the dielectric layer 2 and subsequently producing the recesses 4, which may be etched through openings of a suitable mask.

The recesses 4 may be formed to penetrate the layer forming the web 3, so that the dielectric layer 2 is exposed in the recesses 4. The depth of the recesses 4 may optionally be less than the height h of the web 3. The depth of the recesses 4 is adapted to the filter to be produced, so that the recesses 4 allow the accomodation of a sufficient amount of ink. The height h of the web 3 may typically be in the range between 0.5 µm and 100 µm and may especially be restricted to the range between 10 µm and 20 µm.

The recesses 4 are at least partially filled with ink of different colours to form the filter. The ink is applied by inkjets I, which may especially be generated by an inkjet printing device. Any generally known inkjet printing device may be suitable for this purpose. The inkjet printing device may be used to disperse multiple types of ink into the recesses 4. Inkjets I are indicated in Figure 1 by arrows pointing to the recesses 4. As the inkjets I can individually be directed to the recesses 4, no masks are necessary in this step. The use of a mask can thus be limited to the step of etching the recesses 4. The described method facilitates the production of a large number of colour filters.

An inkjet generated by an inkjet printing device is accurate to within about 5 µm, and lateral deviations from the target area may in particular be limited to an average distance of typically about 1 µm. This accuracy is more than sufficient for typical sizes of the individual filter areas, because the recesses 4 are typically formed to have a lateral dimension D of more than 50 µm, especially of more than 100 µm. The lateral dimension D can be a diameter or a side of a polygon like a square, hexagon or octagon, for example.

The width of the web 3, defining the distance d between neighbouring recesses 4, can be limited to a few microns, typically about 5 µm, for example. The recesses 4 may therefore be arranged at a distance d of less than 10 µm from one another. The pitch of a pixel array formed by the integrated radiation sensors can thus be kept sufficiently small, according to the requirements of the individual application.

Figure 2 shows a pattern of pixels 5 of different colours, which can be formed by the method described. The different colours are indicated in Figure 2 by different hatchings. The first colour pixels A may be red, the second colour pixels B may be green, and the third colour pixels C may be blue, for example, to form an RGB filter. The method is not only suitable for the example shown in Figure 2 but for a large variety of arrangements of the colour pixels A, B, C. The colours may be distributed in many different patterns, according to the individual requirements. In the example shown in Figure 2, the individual filter areas forming the pixels 5 are squares of equal lateral dimension D, but they can instead have other shapes. The shapes and sizes of the individual filter areas may vary between the colour pixels 5 of different arrays, and they may also vary among the colour pixels 5 of the same array.

The shapes of the filter areas of different colours forming the colour pixels 5 are defined by the shapes of the recesses 4 in the web 3 and are easily reproduced by the application of inkjets. The distance d between the pixels 5 may be constant, as shown in the example of Figure 2, or may vary. The pixels 5 may be arranged in a symmetrical pattern or on a regular lattice, as shown in the example of Figure 2, or the pixels 5 may instead be irregularly arranged or statistically distributed. The method is applicable to form multiple colour filters of a large variety of patterns.

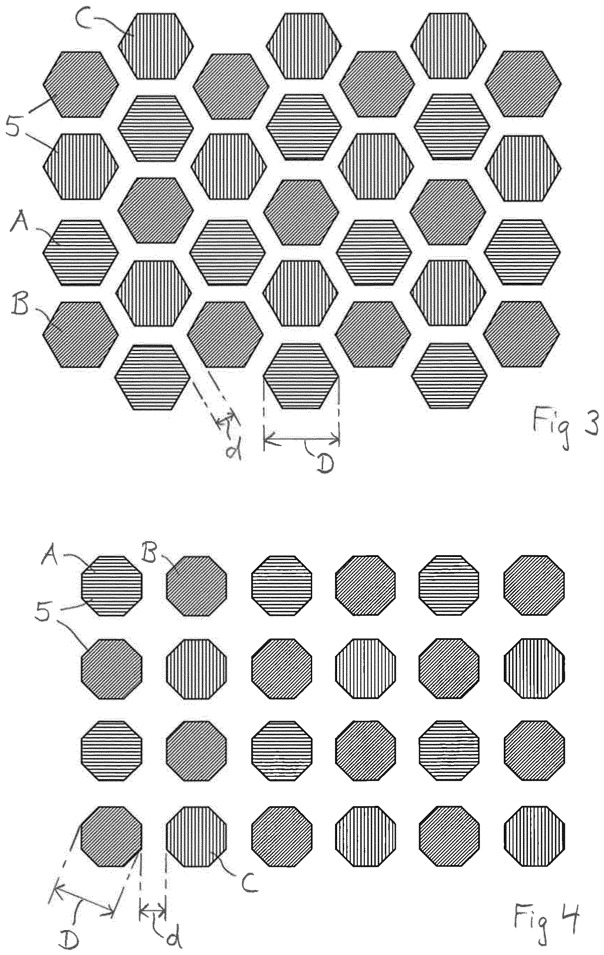

Figure 3 shows a further pattern of pixels 5 of different colours, indicated by different hatchings as in Figure 2. The pattern of Figure 3 comprises pixels 5 in the shape of hexagons. The arrangement of the hexagons within the array and the distribution of the first colour pixels A, the second colour pixels B, and the third colour pixels C may be varied. The distance d between the pixels 5 and a maximal lateral dimension D are indicated in Figure 3.

Figure 4 shows a further pattern of pixels 5 of different colours, indicated by different hatchings as in Figures 2 and 3. The pattern of Figure 4 comprises pixels 5 in the shape of octagons. The arrangement of the octagons within the array and the distribution of the first colour pixels A, the second colour pixels B, and the third colour pixels C may be varied. The distance d between the pixels 5 and a maximal lateral dimension D are indicated in Figure 4.

The method also facilitates the production of multiple types of multiple colour filters during the same manufacturing process. As the filter areas of different colours are defined by the web 3 and no further mask is used, the alignment of the filter areas can easily be optimized within the accuracy of the inkjet printing device. The method has the further advantage that it allows the formation of a multiple colour filter directly on the semiconductor device comprising the radiation sensor, so that no separate filter layer has to be mounted to the semiconductor device.

### List of reference numerals

- 1: semiconductor layer
- 2: dielectric layer
- 3: web
- 4: recess
- 5: colour pixel
- 6: radiation sensor
- A: first colour pixel
- B: second colour pixel
- C: third colour pixel
- d: distance
- D: lateral dimension
- h: height
- I: inkjet

## Claims

1. A method of producing a radiation sensor semiconductor device with a multiple colour filter, comprising:
- providing a semiconductor device comprising a semiconductor layer (1) with at least one radiation sensor (6) and a dielectric layer (2),
- arranging a web (3) comprising a plurality of recesses (4) on the dielectric layer (2), and
- introducing ink of different colours (A, B, C) in the recesses (4) by inkjets (I),
**characterized in that**
- the web (3) is formed from semiconductor material, which is applied on the surface of the dielectric layer (2).

2. The method of claim 1, wherein the web (3) is formed from silicon.

3. The method of one of claims 1 or 2, wherein the web (3) is formed with a height (h) in the range between 0.5 µm and 100 µm.

4. The method of one of claims 1 or 2, wherein the web (3) is formed with a height (h) in the range between 10 µm and 20 µm.

5. The method of one of claims 1 to 4, wherein the recesses (4) are arranged according to an array of colour pixels (5) .

6. The method of one of claims 1 to 5, wherein the recesses (4) are arranged at a distance (d) of less than 10 µm from one another.

7. The method of one of claims 1 to 6, wherein the recesses (4) have a lateral dimension (D) of more than 50 µm.

8. The method of one of claims 1 to 6, wherein the recesses (4) have a lateral dimension (D) of more than 100 µm.

## Patentansprüche

1. Verfahren zum Herstellen eines Strahlungssensorhalbleiterbauteils mit einem Mehrfachfarbfilter, umfassend:
- Bereitstellen eines Halbleiterbauteils, das eine Halbleiterschicht (1) mit mindestens einem Strahlungssensor (6) und eine dielektrische Schicht (2) umfasst,
- Anordnen eines Gitters (3), das mehrere Ausnehmungen (4) umfasst, auf der dielektrischen Schicht (2) und
- Einleiten von Tinte verschiedener Farben (A, B, C) in die Ausnehmungen (4) mittels Tintenstrahlen (I),
**dadurch gekennzeichnet, dass**
- das Gitter (3) aus Halbleitermaterial gebildet ist, das auf die Oberfläche der dielektrischen Schicht (2) aufgebracht ist.

2. Verfahren nach Anspruch 1, wobei das Gitter (3) aus Silicium gebildet ist.

3. Verfahren nach einem der Ansprüche 1 oder 2, wobei das Gitter (3) mit einer Höhe (h) im Bereich zwischen 0,5 µm und 100 µm gebildet ist.

4. Verfahren nach einem der Ansprüche 1 oder 2, wobei das Gitter (3) mit einer Höhe (h) im Bereich zwischen 10 µm und 20 µm gebildet ist.

5. Verfahren nach einem der Ansprüche 1 bis 4, wobei die Ausnehmungen (4) entsprechend einer Anordnung von Farbpixeln (5) angeordnet sind.

6. Verfahren nach einem der Ansprüche 1 bis 5, wobei die Ausnehmungen (4) in einem Abstand (d) von weniger als 10 µm voneinander angeordnet sind.

7. Verfahren nach einem der Ansprüche 1 bis 6, wobei die Ausnehmungen (4) eine seitliche Abmessung (D) von mehr als 50 µm haben.

8. Verfahren nach einem der Ansprüche 1 bis 6, wobei die Ausnehmungen (4) eine seitliche Abmessung (D) von mehr als 100 µm haben.

## Revendications

1. Procédé de production d'un dispositif semiconducteur à capteur de rayonnement présentant un filtre de couleurs multiples, comprenant :
- la mise à disposition d'un dispositif semiconducteur comprenant une couche semiconductrice (1) avec au moins un capteur de rayonnement (6) et une couche diélectrique (2),
- l'agencement d'une toile (3) comprenant une pluralité d'évidements (4) sur la couche diélectrique (2), et
- l'introduction d'encre de différentes couleurs (A, B, C) dans les évidements (4) par jets d'encre (I),
**caractérisé en ce que**
- la toile (3) est composée de matériau semiconducteur, lequel est appliqué sur la surface de la couche diélectrique (2).

2. Le procédé de la revendication 1, sachant que la toile (3) est composée de silicium.

3. Le procédé de l'une des revendications 1 ou 2, sachant que la toile (3) est formée avec une hauteur (h) comprise dans la plage entre 0,5 µm et 100 µm.

4. Le procédé de l'une des revendications 1 ou 2, sachant que la toile (3) est formée avec une hauteur (h) comprise dans la plage entre 10 µm et 20 µm.

5. Le procédé de l'une des revendications 1 à 4, sachant que les évidements (4) sont agencés selon un réseau de pixels de couleur (5).

6. Le procédé de l'une des revendications 1 à 5, sachant que les évidements (4) sont agencés à une distance (d) de moins de 10 µm les uns des autres.

7. Le procédé de l'une des revendications 1 à 6, sachant que les évidements (4) ont une dimension latérale (D) de plus de 50 µm.

8. Le procédé de l'une des revendications 1 à 6, sachant que les évidements (4) ont une dimension latérale (D) de plus de 100 µm.
